# EUROPEAN PATENT SPECIFICATION

(11) **EP 3 513 205 B1**
(45) Date of publication and mention of the grant of the patent: **18.08.2021**
(21) Application number: 17777808.1
(22) Date of filing: 15.09.2017
(51) Int. Cl.: G01R 17/10, G01R 31/52, G01R 31/54, G01R 31/58, G01R 17/14, G01R 27/18

(54) **MONITORING DEVICE AND METHOD OF MONITORING AN IMPEDANCE OF A PROTECTIVE CONDUCTOR, AND CHARGING CONTROL UNIT**
ÜBERWACHUNGSVORRICHTUNG UND VERFAHREN ZUR ÜBERWACHUNG EINER IMPEDANZ EINE SCHÜTZENDEN LEITERS UND LADESTEUERUNGSEINHEIT
DISPOSITIF DE SURVEILLANCE ET PROCÉDÉ DE SURVEILLANCE D'UNE IMPÉDANCE D'UN CONDUCTEUR DE PROTECTION, ET UNITÉ DE COMMANDE DE CHARGE

(30) Priority: 16.09.2016 DE 102016217712
(43) Date of publication of application: 24.07.2019
(73) Proprietor: TE Connectivity Germany GmbH, 64625 Bensheim (DE); Heidelberger Druckmaschinen AG, 69115 Heidelberg (DE)
(72) Inventor: KIPP, Stefan, 69168 Wiesloch (DE); KARRASCH, Gregor, 64683 Einhausen (DE); STROSS, Stefan, 69234 Dielheim (DE); ENGERT, Stefan, 68642 Bürstadt (DE)
(74) Representative: Grünecker Patent- und Rechtsanwälte PartG mbB
(86) International application number: PCT/EP2017/073317
(87) International publication number: WO 2018/050841

(56) References cited:
- EP-A2- 1 087 053
- GB-A- 654 116
- US-A- 4 412 347
- US-B1- 6 301 133

## Description

The present invention relates to a monitoring device and a method of monitoring an impedance of a protective conductor. The present invention further relates to a charging control unit for the control of a charging process of a battery in a motor vehicle, and to a charging cable for the connection of a battery of a motor vehicle with a voltage source, specifically for the charging of an electric vehicle.

Electric vehicles can be charged in various charging modes. These differ *inter alia* with respect to safety devices, communication with the vehicle and charging capacity. For safety reasons, the majority of vehicle manufacturers opt for mode 3 charging. However, mode 2 charging constitutes a form of charging which is compatible with vehicles, involving a conventional domestic plug-and-socket device. These charging modes are defined as follows in international standard IEC 61851-21:2010: mode 3 charging is the safest means of charging a vehicle. This operation is completed in charging stations with special charging equipment in accordance with IEC 61851, or "Electrical Vehicle Supply Equipment" (EVSE), i.e. the charging infrastructure. The charging device is installed in the vehicle. In the charging station, the provision of PWM communication, fault current and overcurrent protection, a cut-off facility and a specific charging socket outlet is stipulated.

Mode 2 charging represents the safest alternative to mode 3 charging, if no charging infrastructure is available. Charging is completed using a conventional domestic plug-and-socket device (e.g. a Schuko or EC plug and socket), with a control and protection function integrated in the charging cable. The charging device is installed in the vehicle.

In the case of mode 3 charging, requirements for the charging infrastructure are clearly defined. In mode 2 charging, however, connection is provided by means of a domestic, industrial or "campsite" plug-and-socket device. The use of standard domestic installations to provide a charging connection for electrical vehicles involves hazards which have not been comprehensively considered in existing solutions. Charging terminals and their feeder lines must be rated for continuous currents of up to 16A. In practice, however, this rating is not comprehensively ensured. There are still domestic installations with no fault current protection facility, and sockets, the feeder line of which is susceptible to hazardous overheating under such continuous loading, as a result of insufficient cross-sectional dimensions. The consequences can be serious. The user must be able to rely upon the fact that the charging process will proceed safely and reliably, as vehicles are frequently charged overnight. Consequently, mode 2 charging cables are known which, over and above requirements defined by the standard, monitor various parameters including e.g. the temperature in the Schuko plug on the infrastructure side, or the presence of a protective conductor, thereby rendering mode 2 charging significantly safer. For mode 2, IEC standard 61851 stipulates a mobile device for the enhancement of the protection level (SPE-PRCD). In addition, for the setting of capacity and the fulfilment of safety requirements, a device for communication with the vehicle (PWM module) is required. These components are combined in an "In-Cable Control and Protecting Device" (IC-CPD). The IC-CPD, which is permanently integrated in the charging cable, monitors the protective conductor connection, and communicates the upper limit for the charging current to the vehicle. In the event of a fault or a power failure, the charging process is immediately interrupted, in order to protect the user and the electric vehicle. The intelligent IC-CPD also detects the incorrect wiring of the socket on the infrastructure side, and additionally monitors the incoming protective conductor, before charging commences.

For the checking of the protective conductor, the PME (protective multiple earthing) resistance between the protective conductor PE and a neutral conductor N in the public grid system is checked against a maximum value. In this case, it must be possible to vary the mains voltage within wide limits, without significantly influencing the evaluation. Moreover, for safety reasons, the evaluation must be executed separately. At present, monitoring devices are available for this purpose, which generate current pulses, and measure the current flowing in the protective conductor. Circuits are moreover known, in which the pulse width of a measuring current is measured using an optical coupler.

GB 654 116 A discloses an A.C. voltage or current regulator which comprises an auto-transformer, the input to which is varied by a saturable reactor controlled by the amplified output of a bridge circuit, one arm of the bridge being a tungsten filament diode, the filament current being varied in accordance with the output voltage or current. In a voltage regulator, the auto-transformer is in series with a saturable reactor across the input terminals, the output being taken from two further terminals. The bridge circuit comprises three resistances together with the tungsten filament diode. The input to this bridge circuit is over two input conductors and the output is taken out in the conventional manner over two conductors which are connected, respectively, between the resistances and a plate of the diode. There is a direct current input to these conductors or terminals. Moreover, it is mentioned that if two of the resistors are of equal value, then the output from the output terminals will be reduced to zero when the resistance of the diode is equal to the resistance of the resistor to which the diode is connected.

US 4 412 347 A iscloses a precision voltage and current source for use, for example, in a transceiver for a carrier-sense multiple access communications network using collision detection wherein the use of one or more precise threshold voltages is required. The threshold voltage(s) is (are) created by a current source which pulls a current through a precise resistive load to yield a precise voltage. A power supply with regulated voltage drives the current source. A feedback voltage from the current source, proportional to the output current of the source, is compared with a reference zener diode voltage; the difference, or error, voltage controls the regulator to drive the regulated power supply voltage in the direction which drives the error voltage to zero. The precise resistive load is preferably formed of two resistors in series. A first threshold voltage is developed across one resistor, corresponding to the average signal level required for receiving signals on the network. A second threshold voltage is developed across the series pair of resistors, corresponding to the minimum average signal level which would be produced by a collision.

However, the known arrangements have a disadvantage, in that they are strongly dependent upon the mains voltage. Moreover, optical coupler circuits are susceptible to significant ageing and temperature drift, such that it must be ensured that these influences are not incorporated in the measurement result.

There is consequently a requirement for a monitoring device for monitoring an impedance of a protective conductor which eliminates the disadvantages of known solutions, and can be produced safely and reliably, but nevertheless cost-effectively.

This object is fulfilled by the subject of the independent patent claims. Advantageous forms of embodiment of the present invention are the subject of the dependent patent claims. Additional non-claimed embodiments, examples and aspects are also presented, in the description, for the better understanding of the invention.

The present invention is based upon the concept of the employment of a modified Wheatstone bridge for monitoring the impedance of the protective conductor. In general, Wheatstone measuring bridges are characterized by high sensitivity, associated with the zero bridge voltage in the balanced state, and by the extensive compensation of stray effects (e.g. temperature influences), associated with the symmetry of the circuit. Specifically, according to the present invention, a monitoring device for monitoring an impedance of a protective conductor has a first voltage divider, arranged between a first input terminal and a second input terminal, which can be connected to a voltage source, wherein the first voltage divider comprises a series connection of a first resistor and a second resistor. A second voltage divider is moreover provided, which comprises a series connection of a third resistor and a bridge diode, wherein the second voltage divider is connected with a first end of the third resistor to the first resistor, and is connectable with a second end to the protective conductor. According to the invention, the monitoring device incorporates a measuring device, which is connected between a first node that is arranged between the first resistor and the second resistor, and a second node, which is arranged between the third resistor and the bridge diode, wherein the second resistor has a resistance value which corresponds to a threshold value for the impedance of the protective conductor, and wherein the measuring device can be employed for the detection of a bridge voltage between the first and second nodes, if the impedance of the protective conductor is greater than the value of the second resistor.

In other words, the Wheatstone bridge is balanced and the bridge voltage is zero, provided that the impedance of the protective conductor does not exceed the value of the second resistor, which is considered as a reference value. IEC standard 61851 specifies that the impedance must not exceed a value of 1.6 kΩ. To a person skilled in the art, however, it will naturally be evident that this value can be selected at will, depending upon the specific application of the monitoring device according to the invention.

For safety reasons, the measuring bridge which is connected to the voltage source and the output signal should be galvanically isolated. To this end, the measuring device can advantageously incorporate an optical coupler having an anode terminal, a cathode terminal, a collector terminal and an emitter terminal, the anode terminal of which is connected to the first node, and the cathode terminal of which is connected to the second node, wherein a signal is present on the emitter terminal, if the impedance of the protective conductor is greater than the value of the second resistor.

For the accurate and noise-free read-out of the output signal generated in the event of a resistance overshoot, the emitter terminal of the optical coupler can be connected to a third voltage divider, which comprises a series circuit of a fourth resistor and a fifth resistor, wherein an output terminal of the monitoring device is connected to a fourth node, which is arranged between the fourth resistor and the fifth resistor.

According to a further advantageous form of embodiment, a rectifier bridge circuit is moreover provided, which is comprised, for example, of four rectifier diodes, and is arranged between a first and second external conductor of the voltage source and the first and second input terminal. In this manner, full-wave rectification can be undertaken, such that the positioning of the Wheatstone bridge in the actual application environment remains flexible, and does not need to be determined in advance.

The monitoring device according to the invention can moreover comprise switching means for the time-limited connection of the monitoring device with a voltage source to be monitored. The advantage of such a test routine, which is only applied for limited and precisely-defined time intervals, is to be considered with respect to enhanced safety.

In order to ensure the secure galvanic isolation of the control circuit for these switching means from power-carrying components, the switching means can comprise a first opto-triac, which is arranged between the first input terminal and the first resistor, and a second opto-triac, which is arranged between the bridge diode and the protective conductor, wherein the first and second opto-triacs are controllable by means of a common control line. Alternatively, the switching means can comprise a first and a second opto-triac, wherein the first opto-triac is arranged between the first input terminal and a first main terminal of the second opto-triac, and a second main terminal of the second opto-triac is connected to the first resistor, and wherein the first and second opto-triacs are controllable by means of a common control line.

The simultaneous triggering of the two opto-triacs can be achieved in a simple manner, wherein the first and second opto-triacs have an anode terminal and a cathode terminal respectively, wherein the anode terminal of the first opto-triac is connected to a supply voltage, the cathode terminal of the first opto-triac is connected to the anode terminal of the second opto-triac, and the cathode terminal of the second opto-triac is connected to a reference potential, via a controllable semiconductor switch.

The present invention further relates to a charging control unit for the control of a charging process of a battery in a motor vehicle, wherein the charging control unit comprises a monitoring device according to the present invention.

Moreover, the present invention can be particularly advantageously employed in a charging cable for the connection of a battery of a motor vehicle with a voltage source, wherein the charging cable incorporates a charging control unit with a monitoring device according to the invention.

The present invention further relates to an associated method for monitoring an impedance of a protective conductor, comprising the following steps:
Connection of a first voltage divider with a first and second external conductor of a voltage source, wherein the first voltage divider comprises a series connection of a first resistor and a second resistor, wherein the second resistor has a resistance value which corresponds to a threshold value for the impedance of the protective conductor;
Connection of a second voltage divider, comprising a series connection of a third resistor and a bridge diode, with a first end of the third resistor to the first resistor, and with a second end to the protective conductor;
Detection of a bridge voltage between a first node, which is arranged between the first resistor and the second resistor, and a second node, which is arranged between the third resistor and the bridge diode, if the impedance of the protective conductor is greater than the value of the second resistor.

As already described, by means of such a Wheatstone bridge, it can be ensured in an exceptionally accurate and reliable manner that the impedance of the protective conductor does not exceed a predefined threshold value. It can thus be confirmed whether the protective conductor is fully-functional - specifically, the presence of an interruption can be ruled out. In this manner, the safety (for example of a charging process) for a user is enhanced.

According to an advantageous development of the method according to the invention, a warning signal can be generated and/or a battery charging process interrupted, if the impedance of the protective conductor is greater than the value of the second resistor, which serves as a reference value. Potential hazards associated with a protective conductor which is not operating as normal can be averted accordingly. Naturally, any other measures for the enhancement of protection can be implemented additionally.

In the interests of an improved understanding of the present invention, the latter is described in greater detail hereinafter, with reference to the exemplary embodiments represented in the attached figures. Herein, the same reference symbols and the same component designations are applied to identical components. Moreover, a number of features, or combinations of features, from the different forms of embodiment represented and described, can also constitute independent, inventive solutions, or solutions according to the invention. Herein:
- **Fig. 1**: shows a schematic representation of the basic principle of a monitoring device, configured as a Wheatstone bridge;
- **Fig. 2**: shows a schematic representation of a measuring device, which can be employed in Fig. 1;
- **Fig. 3**: shows a circuit diagram of a first advantageous form of embodiment of the monitoring device according to the invention;
- **Fig. 4**: shows a circuit diagram of a second advantageous form of embodiment of the monitoring device according to the invention.

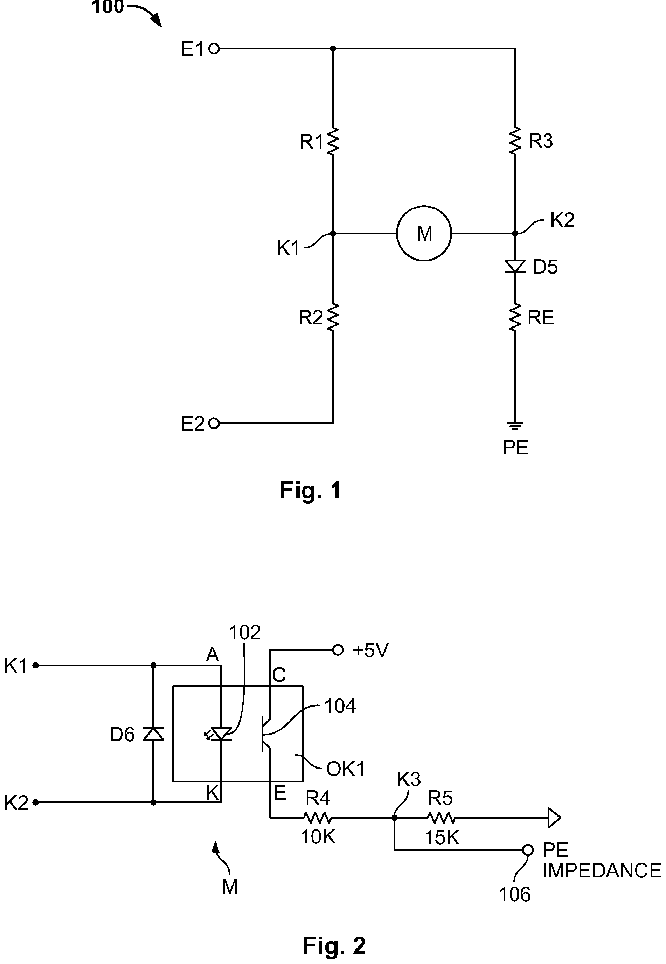

The present invention, with the monitoring device 100 according to the invention, is described in greater detail hereinafter with reference to the figures, and in particular firstly with reference to Figure 1.

Starting from the basic principle, according to the present invention for the monitoring of the resistance between the input terminals E1, E2 and the impedance RE of a protective conductor PE, a Wheatstone bridge circuit is employed. The bridge circuit is comprised of two parallel-connected voltage dividers, which are operated by means of the input voltage applied across the input terminals E1 and E2. The first voltage divider comprises the resistors R1 and R2. The second voltage divider comprises the resistor R3 and a diode D5, as discrete components. The impedance of the protective conductor PE moreover constitutes a virtual resistance element RE.

As is generally known in Wheatstone measuring bridges, a balanced state exists if no voltage is present on the bridging branch between the nodes K1 and K2. A measuring instrument M determines the presence of a voltage in a non-balanced state.

According to the invention, the resistor R2 in the first series circuit is selected such that it corresponds to a threshold value of the resistor RE in the second series circuit. The resistors R1 and R3 have an identical resistance value. In this manner, the presence of a measurable voltage between the nodes K1 and K2 indicates that the bridge is not balanced, and thus that there is deviation of the resistance RE from the threshold value. As further described hereinafter, by means of an appropriate circuit arrangement, it can be ensured that a measuring signal is only generated on the measuring device M in the event of an overshoot of the value of R2, but not upon the undershoot thereof.

If the impedance value RE of the protective conductor PE exceeds the threshold value defined by the reference resistor R2, it can thus be assumed that a malfunction is present. In this case, appropriate measures can be implemented by the measuring means M in order to exclude any hazard. In the specific case of application of the monitoring device 100, by means of an in-cable control and protection device (IC-CPD), which is integrated in the charging cable of a vehicle, for example, the charging process can be interrupted and/or a hazard signal can be generated.

If high voltages are present on the input terminals E1, E2, or in the event of a risk that high currents will flow in the measuring bridge, it is advantageous if the measuring means M generate an output signal which is galvanically separated from the remainder of the measuring bridge.

Figure 2 shows an advantageous configuration of an appropriate measuring circuit M which delivers an output signal which is galvanically separated from the nodes K1, K2 if, in the event of an imbalance on the bridge, a voltage is present between the nodes K1, K2. To this end, the measuring circuit M incorporates an optical coupler OK1. On its input, the optical coupler OK1 has a light-emitting diode 102 between the anode terminal A and the cathode terminal K. If a voltage is present between the anode terminal A and the cathode terminal K in the forward direction of the light-emitting diode, the diode transmits radiation to a phototransistor 104. The connection between the collector C and the emitter E of the optical coupler OK1 is rendered conductive accordingly.

By means of this unipolar connection of the optical coupler OK1, it can be ensured that only a voltage which exceeds the threshold value for impedance is evaluated, but not a voltage which indicates the undershoot of this value (occurring in normal operation).

For the read-out of an output signal (PE impedance) on an output terminal 106, according to the present form of embodiment of the measuring circuit M, the emitter terminal E is connected to a third voltage divider, which incorporates the resistors R4 and R5, and is connected to ground. The collector terminal C is connected to a DC supply voltage of, for example, +5 V. Thus, if the phototransistor 104 is conductive, the output signal can be read-off on the node K3 between the resistors R4 and R5. The output terminal 106 is galvanically separated from the nodes K1 and K2.

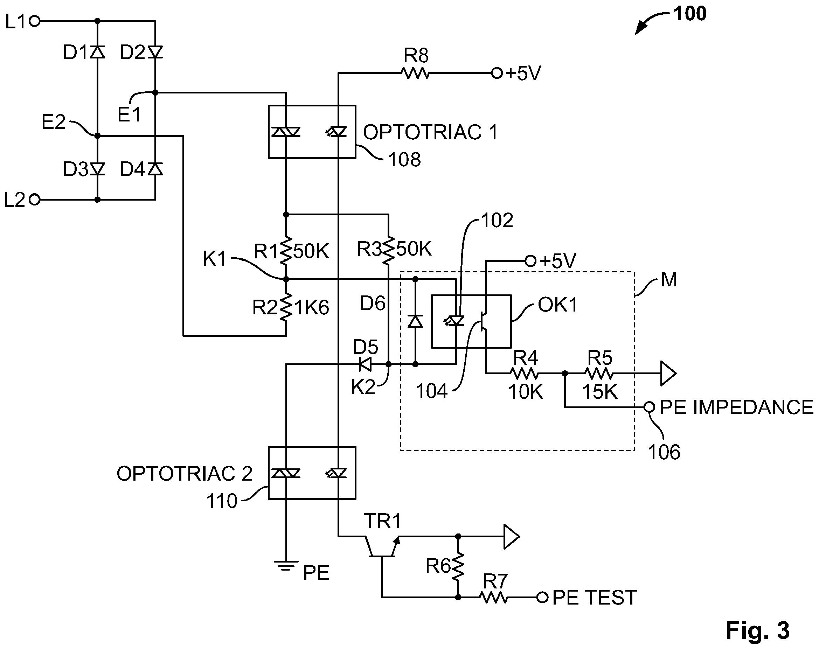

Figure 3, in the form of a detailed circuit diagram, represents a first advantageous form of embodiment of the monitoring device 100 according to the invention. In the form of embodiment represented, the measuring circuit M is unchanged, in relation to the variant shown in Figure 2. In the specific case of application for the monitoring of the impedance of the protective conductor PE in relation to the external conductors L1, L2 of a voltage source, for example a mains voltage, the input terminals E1, E2 of the monitoring device are connected to the external conductors L1, L2 via a full-wave rectifier D1 - D4. In this arrangement, each of the external conductors L1, L2 can be the neutral conductor. The input voltage of the circuit according to the invention is the rectified mains voltage, such that the phase and neutral conductors can be interchanged, with no resulting influence upon the function of the monitoring device 100.

For exemplary purposes, in the form of embodiment represented, resistance values of 50 kΩ have been selected for the resistors R1 and R2, whereas the resistor R2, as a reference value, assumes a value of 1.6 kΩ in accordance with IEC standard 62752 (version 2016), page 120, Figure 12 in para 9.7.7.5.

Moreover, the circuit arrangement according to Figure 3 permits the switch-in of the mimic measuring function for a short time only, such that the current flowing to the protective conductor is switched-in in a temporary manner only. This is primarily advantageous for safety reasons. To this end, a first opto-triac 108 is arranged between the node E1 and the first terminal of the resistor R1. A second opto-triac 110 is arranged between the cathode of the diode D5 and the protective conductor PE.

The opto-triacs 108, 110 each have two main terminals, between which, in a familiar manner to persons skilled in the art, a current can flow if the triac has been triggered by means of an optical signal from the light-emitting diode associated with the respective triac. The triac remains conductive, until such time as an undershoot of holding current occurs. Advantageously, the control circuit of the opto-triac is galvanically isolated from the voltage source to be verified.

In the form of embodiment represented in Figure 3, the light-emitting control diodes of the opto-triacs 108, 110 are connected in series between a supply voltage of +5 V and the ground potential. A switching transistor TR1, which can be switched to the conductive state from a control terminal PE Test, permits a current flow through the light-emitting control diodes, and thus the triggering of the opto-triacs 108, 110. Immediately after the test routine is terminated, the flow of current through the light-emitting diodes is interrupted once more, and the triacs 108, 110 are no longer conductive. Accordingly, the monitoring device according to the invention is no longer actively connected to the voltage source to be tested.

During the test, there is a short-term current flux through the measuring bridge to the protective conductor PE, and the light-emitting diode 102 of the optical coupler OK1 initiates a current flux through the resistors R4, R5 of the third voltage divider, if the impedance value RE of the protective conductor PE exceeds the threshold value 1.6 kΩ of the resistor R2.

Advantageously, the switching value of the optical coupler OK1 is variable within extensive limits, independently of the network voltage, and the switching point is moreover very clearly defined. Moreover, the voltage characteristic generated on the output of the optical coupler OK1 is also substantially independent of ageing and any drift effects on the optical coupler.

The arrangement according to the invention, as indicated, can be employed in charging cables for electrically-powered vehicles. In principle, however, the monitoring device can be generally employed for impedance monitoring on other devices or sensors which require such impedance monitoring, even when connected to supply.

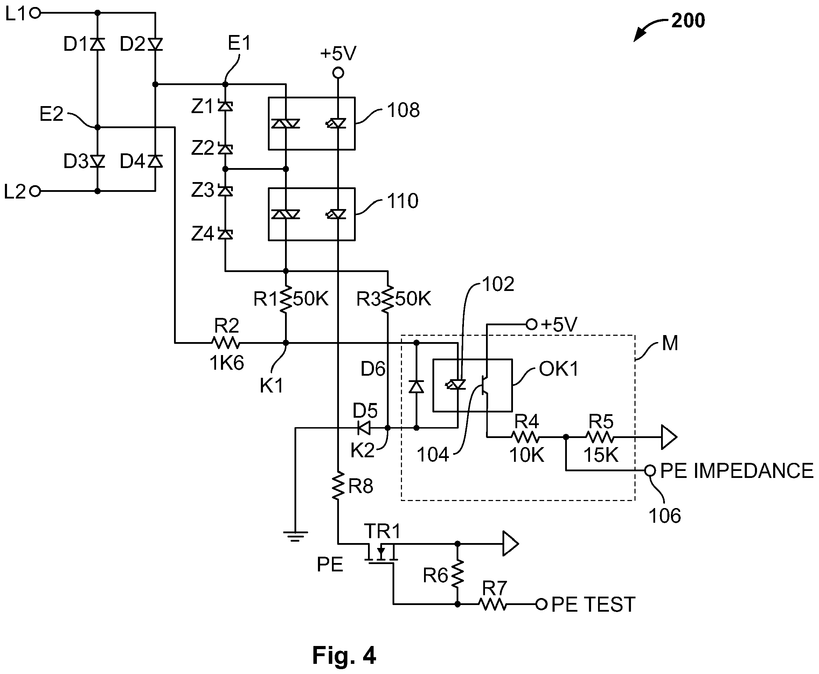

Figure 4 shows a second advantageous form of embodiment of the monitoring device 200 according to the invention. In a distinction from the arrangement represented in Figure 3, the two opto-triacs 108, 110 are arranged directly one after the other, up-circuit of the resistors R1 and R3 Moreover, series circuits comprised of two Zener diodes Z1, Z2 and Z3, Z4 are connected in parallel with the main terminals of the triacs 108, 110. The function of these Zener diodes is to protect against electrostatic discharges (ESD).

Aside from this modification, the monitoring device 200 according to the second form of embodiment functions in the same way as the monitoring device 100 according to the first form of embodiment, as represented in Figure 3.

**List of reference symbols**

| **Reference symbol** | **Description** |
|---|---|
| 100 | Monitoring device, first form of embodiment |
| 102 | Light-emitting diode |
| 104 | Phototransistor |
| 106 | Output terminal |
| 108 | First opto-triac |
| 110 | Second opto-triac |
| 200 | Monitoring device, second form of embodiment |
| M | Measuring device |
| OK1 | Optical coupler |
| E1, E2 | Input terminals |
| D1-D4 | Rectifier diodes |
| D5 | Measuring bridge diode |
| D6 | Diode connected in parallel with the optical coupler |
| R1, R3-R8 | Resistors |
| R2 | Reference resistor |
| L1, L2 | External conductor |
| PE | Protective conductor |
| RE | Impedance of protective conductor |
| Z1-Z4 | Zener diodes |
| TR1 | Switching transistor |

## Claims

1. Monitoring device for monitoring an impedance (RE) of a protective conductor (PE), wherein the monitoring device comprises:
a first voltage divider (R1, R2), arranged between a first input terminal (E1) and a second input terminal (E2), which is connectable to a voltage source, wherein the first voltage divider comprises a series connection of a first resistor (R1) and a second resistor (R2),
a second voltage divider, which comprises a series connection of a third resistor (R3), the third resistor (R3) having a first end and a second end, and a bridge diode (D5), the bridge diode (D5) having an anode and a cathode, wherein the anode is connected to second end of the third resistor (R3), and wherein the second voltage divider is connected with a first end of the third resistor (R3) to the first input terminal (E1), and is connectable with the cathode of the diode (D5) to the protective conductor (PE),
a measuring device (M), which is connected between a first node (K1) that is arranged between the first resistor (R1) and the second resistor (R2), and a second node (K2), which is arranged between the third resistor (R3) and the bridge diode (D5), wherein the measuring device (M) comprises an optical coupler (OK1) having an anode terminal, a cathode terminal, a collector terminal, and an emitter terminal, the anode terminal of which is connected to the first node (K1), and the cathode terminal of which is connected to the second node (K2),
wherein the second resistor (R2) has a resistance value which corresponds to a threshold value for the impedance (RE) of the protective conductor (PE), and wherein the measuring device is operable to detect a bridge voltage between the first and second nodes (K1, K2), and wherein the bridge voltage constitutes the input signal of the optical coupler (OK1), such that an output signal is delivered on the emitter terminal of the optical coupler (OK1), if the impedance (RE) of the protective conductor (PE) is greater than the value of the second resistor (R2).

2. Monitoring device according to Claim 1, further comprising a third voltage divider, which consists of a series connection of a fourth resistor (R4) and a fifth resistor (R5), the fourth resistor (R4) having a first end and a second end, the fifth resistor (R5) having a first end and a second end, and the second end of the fourth resistor (R4) being connected to the first end of the fifth resistor (R5),
wherein:
the emitter terminal is connected to the first end of the fourth resistor (R4);
the connection of the second end of the fourth resistor (R4) and the first end of the fifth resistor (R5) corresponds to a fourth node; and
an output terminal of the monitoring device is connected to said fourth node.

3. Monitoring device according to any of the preceding claims, further comprising a rectifier bridge circuit (D1, D2, D3, D4), which is arranged between a first and second external conductor (L1, L2) of the voltage source and the first and second input terminal (E1, E2).

4. Monitoring device according to any of the preceding claims, further comprising switching means (108, 110) for the time-limited connection of the monitoring device with a voltage source to be monitored.

5. Monitoring device according to Claim 4, wherein the switching means comprise a first opto-triac (108), the first opto-triac (108) having an anode, a cathode, a first main terminal, and a second main terminal, wherein the first main terminal of the first opto-triac (108) is connected to the first input terminal (E1) and wherein the second main terminal of the first opto-triac (108) is connected to the first resistor (R1), and a second opto-triac (110), having an anode, a cathode, a first main terminal, and a second main terminal, wherein the first main terminal of the second opto-triac (110) is connected to the cathode of the bridge diode (D5) and the second main terminal of the second opto-triac is connectable to the protective conductor, and wherein the first and second opto-triacs (108, 110) are controllable by means of a common control line.

6. Monitoring device according to Claim 4, wherein the switching means comprise a first and second opto-triac (108, 110), the first opto-triac (108) having an anode, a cathode, a first main terminal, and a second main terminal, wherein first main terminal of the first opto-triac (108) is connected to the first input terminal (E1), wherein the second opto-triac (110) has an anode, a cathode, a first main terminal, and a second main terminal, wherein the first main terminal of the second opto-triac (110) is connected to the second main terminal of the first opto-triac (108), and wherein the second main terminal of the second opto-triac (110) is connected to the first resistor (R1), and wherein the first and second opto-triacs (108, 110) are controllable by means of a common control line.

7. Monitoring device according to Claim 5 or 6, wherein the anode terminal of the first opto-triac (108) is connected to a supply voltage, the cathode terminal of the first opto-triac (108) is connected to the anode terminal of the second opto-triac (110), and the cathode terminal of the second opto-triac (110) is connected to a reference potential, via a controllable semiconductor switch.

8. Charging control unit for the control of a charging process of a battery in a motor vehicle, wherein the charging control unit comprises a monitoring device according to any of the preceding claims.

9. Charging cable for the connection of a battery of a motor vehicle with a voltage source, wherein the charging cable comprises a charging control unit according to Claim 8.

10. Method for monitoring an impedance (RE) of a protective conductor (PE), comprising the following steps:
connecting a first voltage divider between a first and second external conductor (L1, L2) of a voltage source, wherein the first voltage divider comprises a series connection of a first resistor (R1) and a second resistor (R2), wherein the second resistor (R2) has a resistance value which corresponds to a threshold value for the impedance (RE) of the protective conductor (PE);
connecting a second voltage divider, comprising a series connection of a third resistor (R3), the third resistor (R3) having a first end and a second end, and a bridge diode (D5), the bridge diode (D5) having an anode and a cathode, with a first end of the third resistor (R3) to the first external conductor (L1) and with a cathode of the diode (D5) to the protective conductor (PE);
detecting a bridge voltage between a first node (K1), which is arranged between the first resistor (R1) and the second resistor (R2), and a second node (K2), which is arranged between the third resistor (R3) and the bridge diode (D5), and wherein the bridge voltage constitutes the input signal of an optical coupler (OK1) having an anode terminal, a cathode terminal, a collector terminal, and an emitter terminal, the anode terminal of which is connected to the first node (K1), and the cathode terminal of which is connected to the second node (K2), such that an output signal is delivered on the emitter terminal of the optical coupler (OK1), if the impedance (RE) of the protective conductor (PE) is greater than the value of the second resistor (R2).

11. Method according to Claim 10, wherein the voltage of the first and second external conductors (L1, L2) is rectified by means of a rectifier bridge circuit (D1, D2, D3, D4).

12. Method according to Claim 10 or 11, wherein the monitoring of the impedance (RE) of the protective conductor (PE) is only conducted during short test intervals.

13. Method according to any of Claims 10 to 12, wherein a warning signal is generated and/or a battery charging process is interrupted if the impedance (RE) of the protective conductor (PE) is greater than the value of the second resistor (R2).

## Patentansprüche

1. Überwachungsvorrichtung zum Überwachen einer Impedanz (RE) eines Schutzleiters (PE), wobei die Überwachungsvorrichtung umfasst:
einen ersten Spannungsteiler (R1, R2), der zwischen einem ersten Eingangsanschluss (E1) und einem zweiten Eingangsanschluss (E2) angeordnet ist, der an eine Spannungsquelle angeschlossen werden kann, wobei der erste Spannungsteiler eine Reihenschaltung aus einem ersten Widerstand (R1) und einem zweiten Widerstand (R2) umfasst,
einen zweiten Spannungsteiler, der eine Reihenschaltung aus einem dritten Widerstand (R3), wobei der dritte Widerstand (R3) ein erstes Ende und ein zweites Ende hat, und einer Brückendiode (D5) umfasst, wobei die Brückendiode (D5) eine Anode und eine Kathode aufweist, die Anode mit dem zweiten Ende des dritten Widerstandes (R3) verbunden ist und der zweite Spannungsteiler an ein erstes Ende des dritten Widerstandes (R3) mit dem ersten Eingangsanschluss (E1) angeschlossen ist und an die Kathode der Diode (D5) mit dem Schutzleiter (PE) angeschlossen werden kann,
eine Messvorichtung (M), die zwischen einen ersten Knoten (K1), der zwischen dem ersten Widerstand (R1) und dem zweiten Widerstand (R2) angeordnet ist, und einen zweiten Knoten (K2) geschaltet ist, der zwischen dem dritten Widerstand (R3) und der Brückendiode (D5) angeordnet ist, wobei die Messvorichtung (M) einen Optokoppler (OK1) mit einem Anoden-Anschluss, einem Kathoden-Anschluss, einem Kollektor-Anschluss und einem Emitter-Anschluss umfasst, dessen Anoden-Anschluss an den ersten Knoten (K1) angeschlossen ist und dessen Kathoden-Anschluss an den zweiten Knoten (K2) angeschlossen ist ist,
wobei der zweite Widerstand (R2) einen Widerstandswert hat, der einem Schwellenwert für die Impedanz (RE) des Schutzleiters (PE) entspricht, und die Messvorichtung so betrieben werden kann, dass sie eine Brückenspannung zwischen dem ersten und dem zweiten Knoten (K1, K2) erfasst, und die Brückenspannung das Eingangssignal des Optokopplers (OK1) bildet, so dass ein Ausgangssignal an dem Emitter-Anschluss des Optokopplers (OK1) ausgegeben wird, wenn die Impedanz (RE) des Schutzleiters (PE) größer ist als der Wert des zweiten Widerstandes (R2).

2. Überwachungsvorrichtung nach Anspruch 1, die des Weiteren einen dritten Spannungsteiler umfasst, der aus einer Reihenschaltung aus einem vierten Widerstand (R4) und einem fünften Widerstand (R5) besteht, wobei der vierte Widerstand (R4) ein erstes Ende und ein zweites Ende hat, der fünfte Widerstand (R5) ein erstes Ende und ein zweites Ende hat und das zweite Ende des vierten Widerstandes (R4) an das erstn Ende des fünften Widerstandes (R5) angeschlossen ist,
und wobei
der Emitter-Anschluss an das erste Ende des vierten Widerstandes (R4) angeschlossen ist, die Verbindung des zweiten Endes des vierten Widerstandes (R4) und des ersten Endes des fünften Widerstandes (R5) einem vierten Knoten entspricht und ein Ausgangsanschluss der Überwachungsvorrichtung an den vierten Knoten angeschlossen ist.

3. Überwachungsvorrichtung nach einem der vorangehenden Ansprüche, die des Weiteren eine Gleichrichterbrückenschaltung (D1, D2, D3, D4) umfasst, die zwischen einem ersten und einem zweiten externen Leiter (L1, L2) der Spannungsquelle und dem ersten und dem zweiten Eingangsanschluss (E1, E2) angeordnet ist.

4. Überwachungsvorrichtung nach einem der vorangehenden Ansprüche, die des Weiteren Schalteinrichtungen (108, 110) für die zeitlich begrenzte Verbindung der Überwachungsvorrichtung mit einer zu überwachenden Spannungsquelle umfasst.

5. Überwachungsvorrichtung nach Anspruch 4, wobei die Schalteinrichtungen einen ersten Opto-Triac (108) umfassen, der erste Opto-Triac (108) eine Anode, eine Kathode, einen ersten Hauptanschluss und einen zweiten Hauptanschluss aufweist, der erste Hauptanschluss des ersten Opto-Triac (108) an den ersten Eingangsanschluss (E1) angeschlossen ist und der zweite Hauptanschluss des ersten Opto-Triac (108) an den ersten Widerstand (R1) angeschlossen ist, sowie einen zweiten Opto-Triac (110) umfassen, der eine Anode, eine Kathode, einen ersten Hauptanschluss und einen zweiten Hauptanschluss aufweist, wobei der erste Hauptanschluss des zweiten Opto-Triac (110) an die Kathode der Brückendiode (D5) angeschlossen ist und der zweite Hauptanschluss des zweiten Opto-Triac mit dem Schutzleiter verbunden werden kann und der erste und der zweite Opto-Triac (108, 110) mittels einer gemeinsamen Steuerleitung gesteuert werden können.

6. Überwachungsvorrichtung nach Anspruch 4, wobei die Schalteinrichtungen einen ersten und einen zweiten Opto-Triac (108) umfassen, der erste Opto-Triac (108) eine Anode, eine Kathode, einen ersten Hauptanschluss und einen zweiten Hauptanschluss aufweist, der erste Hauptanschluss des ersten Opto-Triac (108) mit dem ersten Eingangsanschluss (E1) verbunden ist, der zweite Opto-Triac (110) eine Anode, eine Kathode, einen ersten Hauptanschluss und einen zweiten Hauptanschluss aufweist, wobei der erste Hauptanschluss des zweiten Opto-Triac (110) an den zweiten Hauptanschluss des ersten Opto-Triac (108) angeschlossen ist und der zweite Hauptanschluss des zweiten Opto-Triac (110) an den ersten Widerstand, (R1) angeschlossen ist und der erste und der zweite Opto-Triac (108, 110) mittels einer gemeinsamen Steuerleitung gesteuert werden können.

7. Überwachungsvorrichtung nach Anspruch 5 oder 6, wobei der Anoden-Anschluss des ersten Opto-Triac (108) an eine Versorgungsspannung angeschlossen ist, der Kathoden-Anschluss des ersten Opto-Triac (108) an den Anoden-Anschluss des zweiten Opto-Triac (110) angeschlossen ist und der Kathoden-Anschluss des zweiten Opto-Triac (110) über einen steuerbaren Halbleiterschalter mit einem Bezugspotential verbunden ist.

8. Ladesteuerungs-Einheit zur Steuerung eines Ladevorgangs einer Batterie in einem Kraftfahrzeug, wobei die Ladesteuerungs-Einheit eine Überwachungsvorrichtung nach einem der vorangehenden Ansprüche umfasst.

9. Ladekabel für die Verbindung einer Batterie eines Kraftfahrzeugs mit einer Spannungsquelle, wobei das Ladekabel eine Ladesteuerungs-Einheit nach Anspruch 8 umfasst.

10. Verfahren zum Überwachen einer Impedanz (RE) eines Schutzleiters (PE), das die folgenden Schritte umfasst:
Schalten eines ersten Spannungsteilers zwischen einen ersten und einen zweiten externen Leiter (L1, L2) einer Spannungsquelle, wobei der erste Spannungsteiler eine Reihenschaltung aus einem ersten Widerstand (R1) und einem zweiten Widerstand (R2) umfasst, und der zweite Widerstand (R2) einen Widerstandswert hat, der einem Schwellenwert für die Impedanz (RE) des Schutzleiters (PE) entspricht;
Anschließen eines zweiten Spannungsteilers, der eine Reihenschaltung aus einem dritten Widerstand (R3), wobei der dritte Widerstand (R3) ein erstes Ende und ein zweites Ende hat, und einer Brückendiode (D5) umfasst, wobei die Brückendiode (D5) eine Anode und eine Kathode aufweist, an ein erstes Ende des dritten Widerstandes (R3) mit dem ersten externen Leiter (L1) und an eine Kathode der Diode (D5) mit dem Schutzleiter (PE);
Erfassen einer Brückenspannung zwischen einem ersten Knoten (K1), der zwischen dem ersten Widerstand (R1) und dem zweiten Widerstand (R2) angeordnet ist, und einem zweiten Knoten (K2), der zwischen dem dritten Widerstand (R3) und der Brückendiode (D5) angeordnet ist, und wobei die Brückenspannung das Eingangssignal eines Optokopplers (OK1) bildet, der einen Anoden-Anschluss, einen Kathoden-Anschluss, einen Kollektor-Anschluss und einen Emitter-Anschluss aufweist, dessen Anoden-Anschluss an den ersten Knoten (K1) angeschlossen ist und dessen Kathoden-Anschluss an den zweiten Knoten (K2) angeschlossen ist, so dass an dem Emitter-Anschluss des Optokopplers (OK1) ein Ausgangssignal ausgegeben wird, wenn die Impedanz (RE) des Schutzleiters (PE) größer ist als der Wert des zweiten Widerstandes (R2).

11. Verfahren nach Anspruch 10, wobei die Spannung des ersten und des zweiten externen Leiters (L1, L2) mittels einer Gleichrichterbrückenschaltung (D1, D2, D3, D4) gleichgerichtet wird.

12. Verfahren nach Anspruch 10 oder 11, wobei das Überwachen der Impedanz (RE) des Schutzleiters (PE) nur während kurzer Prüfintervalle durchgeführt wird.

13. Verfahren nach einem der Ansprüche 10 bis 12, wobei ein Warnsignal erzeugt und/oder ein Batterieladevorgang unterbrochen wird, wenn die Impedanz (RE) des Schutzleiters (PE) größer ist als der Wert des zweiten Widerstandes (R2).

## Revendications

1. Dispositif de surveillance pour surveiller une impédance (RE) d'un conducteur de protection (PE),
dans lequel le dispositif de surveillance comprend :
un premier diviseur de tension (R1, R2), disposé entre une première borne d'entrée (E1) et une deuxième borne d'entrée (E2), qui peut être connecté à une source de tension, dans lequel le premier diviseur de tension comprend un montage en série d'une première résistance (R1) et d'une deuxième résistance (R2),
un deuxième diviseur de tension, qui comprend une connexion en série d'une troisième résistance (R3), la troisième résistance (R3) ayant une première extrémité et une deuxième extrémité, et une diode en pont (D5), la diode en pont (D5) ayant une anode et une cathode, dans laquelle l'anode est connectée à la deuxième extrémité de la troisième résistance (R3), et dans lequel le deuxième diviseur de tension est connecté avec une première extrémité de la troisième résistance (R3) à la première borne d'entrée (E1), et peut être connecté avec la cathode de la diode (D5) au conducteur de protection (PE), un dispositif de mesure (M), qui est connecté entre un premier nœud (K1) qui est disposé entre la première résistance (R1) et la deuxième résistance (R2), et un deuxième nœud (K2), qui est disposé entre la troisième résistance (R3) et la diode en pont (D5), dans lequel le dispositif de mesure (M) comprend un coupleur optique (OK1) ayant une borne d'anode, une borne de cathode, une borne de collecteur, et une borne d'émetteur, dont la borne d'anode est connectée au premier nœud (K1), et dont la borne de cathode est connectée au deuxième nœud (K2),
dans lequel la deuxième résistance (R2) a une valeur de résistance qui correspond à une valeur de seuil pour l'impédance (RE) du conducteur de protection (PE), et dans lequel le dispositif de mesure est utilisable pour détecter une tension de pont entre les premier et deuxième nœuds (K1, K2), et dans lequel la tension de pont constitue le signal d'entrée du coupleur optique (OK1), de sorte qu'un signal de sortie est délivré sur la borne d'émetteur du coupleur optique (OK1), si l'impédance (RE) du conducteur de protection (PE) est supérieure à la valeur de la deuxième résistance (R2).

2. Dispositif de surveillance selon la revendication 1, comprenant en outre un troisième diviseur de tension, qui consiste en un montage en série d'une quatrième résistance (R4) et d'une cinquième résistance (R5), la quatrième résistance (R4) ayant une première extrémité et une deuxième extrémité, la cinquième résistance (R5) ayant une première extrémité et une deuxième extrémité, et la deuxième extrémité de la quatrième résistance (R4) étant connectée à la première extrémité de la cinquième résistance (R5),
dans lequel:
la borne d'émetteur est connectée à la première extrémité de la quatrième résistance (R4);
la connexion de la deuxième extrémité de la quatrième résistance (R4) et de la première extrémité de la cinquième résistance (R5) correspond à un quatrième nœud; et
une borne de sortie du dispositif de surveillance est connectée audit quatrième nœud.

3. Dispositif de surveillance selon l'une quelconque des revendications précédentes, comprenant en outre un circuit de pont redresseur (D1, D2, D3, D4), qui est disposé entre un premier et un deuxième conducteur externe (L1, L2) de la source de tension et la première et la deuxième borne d'entrée (E1, E2).

4. Dispositif de surveillance selon l'une quelconque des revendications précédentes, comprenant en outre des moyens de commutation (108, 110) pour la connexion limitée dans le temps du dispositif de surveillance avec une source de tension à surveiller.

5. Dispositif de surveillance selon la revendication 4, dans lequel les moyens de commutation comprennent un premier opto-triac (108), le premier opto-triac (108) ayant une anode, une cathode, une première borne principale, et une deuxième borne principale, dans lequel la première borne principale du premier opto-triac (108) est connectée à la première borne d'entrée (E1) et dans lequel la deuxième borne principale du premier opto-triac (108) est connectée à la première résistance (R1), et un deuxième opto-triac (110), ayant une anode, une cathode, une première borne principale et une deuxième borne principale, dans lequel la première borne principale du deuxième opto-triac (110) est connectée à la cathode de la diode en pont (D5) et la deuxième borne principale du deuxième opto-triac peut être connectée au conducteur de protection, et dans lequel les premier et deuxième opto-triacs (108, 110) peuvent être commandés au moyen d'une ligne de commande commune.

6. Dispositif de surveillance selon la revendication 4, dans lequel les moyens de commutation comprennent un premier et un deuxième opto-triac (108, 110), le premier opto-triac (108) ayant une anode, une cathode, une première borne principale, et une deuxième borne principale, dans lequel la première borne principale du premier opto-triac (108) est connectée à la première borne d'entrée (E1), dans lequel le deuxième opto-triac (110) a une anode, une cathode, une première borne principale, et une deuxième borne principale, dans lequel la première borne principale du deuxième opto-triac (110) est connectée à la deuxième borne principale du premier opto-triac (108), et dans lequel la deuxième borne principale du deuxième opto-triac (110) est connectée à la première résistance (R1), et dans lequel les premier et deuxième opto-triacs (108, 110) sont contrôlables au moyen d'une ligne de commande commune.

7. Dispositif de surveillance selon la revendication 5 ou 6, dans lequel la borne d'anode du premier opto-triac (108) est reliée à une tension d'alimentation, la borne de cathode du premier opto-triac (108) est reliée à la borne d'anode du deuxième opto-triac (110), et la borne de cathode du deuxième opto-triac (110) est reliée à un potentiel de référence, via un commutateur à semi-conducteur commandable.

8. Unité de commande de charge pour la commande d'un processus de charge d'une batterie dans un véhicule à moteur,
dans lequel l'unité de commande de charge comprend un dispositif de surveillance selon l'une quelconque des revendications précédentes.

9. Câble de charge pour la connexion d'une batterie d'un véhicule automobile avec une source de tension,
dans lequel le câble de charge comprend une unité de commande de charge selon la revendication 8.

10. Procédé de contrôle d'une impédance (RE) d'un conducteur de protection (PE), comprenant les étapes suivantes:
connecter un premier diviseur de tension entre un premier et un deuxième conducteur externe (L1, L2) d'une source de tension, dans lequel le premier diviseur de tension comprend une connexion en série d'une première résistance (R1) et d'une deuxième résistance (R2), dans lequel la deuxième résistance (R2) a une valeur de résistance qui correspond à une valeur de seuil pour l'impédance (RE) du conducteur de protection (PE);
connecter un deuxième diviseur de tension, comprenant une connexion en série d'une troisième résistance (R3), la troisième résistance (R3) ayant une première extrémité et une deuxième extrémité, et une diode en pont (D5), la diode en pont (D5) ayant une anode et une cathode, avec une première extrémité de la troisième résistance (R3) au premier conducteur externe (L1) et avec une cathode de la diode (D5) au conducteur de protection (PE);
détecter une tension de pont entre un premier nœud (K1), qui est disposé entre la première résistance (R1) et la deuxième résistance (R2), et un deuxième nœud (K2), qui est disposé entre la troisième résistance (R3) et la diode de pont (D5), et dans lequel la tension de pont constitue le signal d'entrée d'un coupleur optique (OK1) ayant une borne d'anode, une borne de cathode, une borne de collecteur et une borne d'émetteur, une borne de collecteur, et une borne d'émetteur, dont la borne d'anode est connectée au premier nœud (K1), et dont la borne de cathode est connectée au deuxième nœud (K2), de sorte qu'un signal de sortie est délivré sur la borne d'émetteur du coupleur optique (OK1), si l'impédance (RE) du conducteur de protection (PE) est supérieure à la valeur de la deuxième résistance (R2).

11. Procédé selon la revendication 10, dans lequel la tension des premier et deuxième conducteurs externes (L1, L2) est redressée au moyen d'un circuit en pont redresseur (D1, D2, D3, D4).

12. Procédé selon les revendications 10 ou 11, dans lequel la surveillance de l'impédance (RE) du conducteur de protection (PE) n'est effectuée que pendant de courts intervalles de test.

13. Procédé selon l'une quelconque des revendications 10 à 12, dans lequel un signal d'alerte est généré et/ou un processus de charge de la batterie est interrompu si l'impédance (RE) du conducteur de protection (PE) est supérieure à la valeur de la deuxième résistance (R2).
